# EUROPÄISCHE PATENTSCHRIFT

(11) **EP 3 186 032 B1**
(45) Veröffentlichungstag und Bekanntmachung des Hinweises auf die Patenterteilung: **25.04.2018**
(21) Anmeldenummer: 15760397.8
(22) Anmeldetag: 21.08.2015
(51) Int. Cl.: H05K 3/34, B23K 35/26, B23K 35/30, B23K 35/02, B23K 35/362

(54) **VERFAHREN ZUR HERSTELLUNG EINER LÖTVERBINDUNG**
METHOD FOR PRODUCING A SOLDER CONNECTION
PROCÉDÉ DE PRODUCTION D'UNE LIAISON SOUDÉE

(30) Priorität: 27.08.2014 EP 14182454
(43) Veröffentlichungstag der Anmeldung: 05.07.2017
(73) Patentinhaber: Heraeus Deutschland GmbH & Co. KG, 63450 Hanau (DE)
(72) Erfinder: FRITZSCHE, Sebastian, 63454 Hanau (DE); SCHULZE, Jürgen, 14480 Potsdam (DE); TRODLER, Jörg, 63526 Erlensee (DE)
(74) Vertreter: Heraeus IP
(86) Internationale Anmeldenummer: PCT/EP2015/069222
(87) Internationale Veröffentlichungsnummer: WO 2016/030287

(56) Entgegenhaltungen:
- EP-A1- 0 810 051
- EP-A2- 2 042 260
- EP-A2- 2 158 997
- WO-A1-2011/009597

## Beschreibung

Die vorliegende Erfindung betrifft ein Verfahren zum stoffschlüssigen Verbinden eines elektronischen Bauteils mit einem Substrat. WO 2011/009597 A1 offenbart ein Verfahren zum stoffschlüssigen Verbinden eines elektronischen Bauteils mit einem Substrat, bei dem man a) ein elektronisches Bauteil mit einer ersten zu verbindenden Oberfläche und ein Substrat mit einer zweiten zu verbindenden Oberfläche bereitstellt, b) auf wenigstens eine der zu verbindenden Oberflächen eine Lotpaste aufträgt, c) das elektronische Bauteil und das Substrat so anordnet, dass die erste zu verbindende Oberfläche des elektronischen Bauteils mit der zweiten zu verbindenden Oberfläche des Substrats über die Lotpaste in Kontakt steht, und d) die Anordnung aus c) verlötet, um eine stoffschlüssige Verbindung zwischen dem elektronischen Bauteil und dem Substrat zu erzeugen. Die Auftragsdicke der Lotpaste beträgt dabei wenigstens 20 µm. Die in dem Verfahren verwendete Lotpaste enthält (i) 10 - 30 Gew.-% (Gewichts-%) Kupferpartikel, (ii) 60 - 80 Gew.-% Partikel aus wenigstens einem Stoff, der aus der Gruppe ausgewählt ist, die aus Zinn und Zinn-Kupfer-Legierungen besteht, und (iii) 3 - 30 Gew.-% Flussmittel, wobei der mittlere Teilchendurchmesser der Kupferpartikel und der Partikel aus wenigstens einem Stoff, der aus der Gruppe ausgewählt ist, die aus Zinn und Zinn-Kupfer-Legierungen besteht, ≤ 15 µm beträgt.

In dem in DVS-Berichte, Elektronische Baugruppen und Leiterplatten EBL 2014 (ISBN 978-3-87155-573-2) erschienenen Aufsatz "Standard-Reflowlöten für Anwendungen bis 300 °C - ein Widerspruch? Ergebnisse aus dem Verbundprojekt HotPowCon" berichten A. Fix et al. u.a. über ein Lötverfahren bei dem mit zwei separat applizierten Pasten gearbeitet wird, d.h. mit einer Paste, die Kupferpartikel enthält, und mit einer Lotmetallpartikel enthaltenden Paste.

Die mit dem Verfahren nach WO 2011/009597 A1 geschaffenen Lötverbindungen erreichen eine gute Festigkeit, haben sich allerdings im Zuge der Entwicklungsarbeiten zur vorliegenden Erfindung hinsichtlich Homogenität und Vermeidung von Hohlräumen und letztlich auch in der Zuverlässigkeit insbesondere unter Hochtemperaturbedingungen im Bereich von beispielsweise 250 bis 300 °C als verbesserungsfähig erwiesen.

Die vorliegende Erfindung betrifft daher ein Verfahren zum stoffschlüssigen Verbinden eines elektronischen Bauteils mit einem Substrat, bei dem man
a) ein elektronisches Bauteil mit einer ersten zu verbindenden Oberfläche und ein Substrat mit einer zweiten zu verbindenden Oberfläche bereitstellt,
b) auf wenigstens eine der zu verbindenden Oberflächen eine Kupferpaste durch Siebdruckverfahren, Schablonendruckverfahren, Jet- oder Dispenstechnik appliziert und die Schicht aus Kupferpaste trocknet,
c1) ein Lotmittel auf die getrocknete Schicht aus Kupferpaste appliziert und das elektronische Bauteil und das Substrat so anordnet, dass die erste zu verbindende Oberfläche des elektronischen Bauteils mit der zweiten zu verbindenden Oberfläche des Substrats über die Zweischichtenkombination aus getrockneter Kupferpaste und Lotmittel in Kontakt steht,
   oder
c2) das elektronische Bauteil und das Substrat so anordnet, dass die erste zu verbindende Oberfläche des elektronischen Bauteils mit der zweiten zu verbindenden Oberfläche des Substrats über die getrocknete Kupferpaste in Kontakt steht und ein Lotmittel neben die Schicht aus getrockneter Kupferpaste appliziert und,
d) die in Schritt c1) oder c2) geschaffene Anordnung bei einer im Bereich von 240 - 260 °C liegenden Löttemperatur verlötet, um eine stoffschlüssige Verbindung zwischen dem elektronischen Bauteil und dem Substrat zu erzeugen, wobei es sich bei dem in Verfahrensschritt c1) oder c2) verwendeten Lotmittel um eine Lotpaste oder um ein oder mehrere Lotformteile aus Lotmetall handelt, wobei die Applikation der Lotpaste durch Siebdruckverfahren, Schablonendruckverfahren, Jet- oder Dispenstechnik erfolgt, wobei die Kupferpaste (i) 66 - 99 Gew.-% mindestens einer Art von jeweils einen Phosphoranteil von 0 bis ≤ 500 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 1 - 20 Gew.-% Vehikel enthält, wobei der mittlere Teilchendurchmesser der metallischen Partikel (i) und (ii) ≤ 15 µm beträgt,
   wobei die kupferreichen Kupfer/Zink-Legierungen oder kupferreichen Kupfer/ZinnLegierungen eine Zusammensetzung von 60 bis 99,5 Gew.-% Kupfer und 0,5 bis 40 Gew.- % Zink oder Zinn aufweisen, und
   wobei die zinnreichen Zinn/Kupfer-, Zinn/Silber- oder Zinn/Kupfer/Silber-Legierungen eine Zusammensetzung von 95 - 99,5 Gew.-% Zinn und 0,5 - 5 Gew.-% Kupfer, Silber oder Kupfer plus Silber aufweisen. In einer ersten Ausführungsform handelt es sich demnach um ein Verfahren zum stoffschlüssigen Verbinden eines elektronischen Bauteils mit einem Substrat, bei dem man
   a) ein elektronisches Bauteil mit einer ersten zu verbindenden Oberfläche und ein Substrat mit einer zweiten zu verbindenden Oberfläche bereitstellt,
   b) auf wenigstens eine der zu verbindenden Oberflächen eine Kupferpaste durch Siebdruckverfahren, Schablonendruckverfahren, Jet- oder Dispenstechnik appliziert und die die Schicht aus Kupferpaste trocknet,
   c) ein Lotmittel auf die getrocknete Schicht aus Kupferpaste appliziert und das elektronische Bauteil und das Substrat so anordnet, dass die erste zu verbindende Oberfläche des elektronischen Bauteils mit der zweiten zu verbindenden Oberfläche des Substrats über die Zweischichtenkombination aus getrockneter Kupferpaste und Lotmittel in Kontakt steht, und
   d) die in Schritt c) geschaffene Anordnung bei einer im Bereich von 240 - 260 °C liegenden Löttemperatur verlötet, um eine stoffschlüssige Verbindung zwischen dem elektronischen Bauteil und dem Substrat zu erzeugen, wobei es sich bei dem in Verfahrensschritt c) verwendeten Lotmittel um eine Lotpaste oder um ein oder mehrere Lotformteile aus Lotmetall handelt, wobei die Applikation der Lotpaste durch Siebdruckverfahren, Schablonendruckverfahren, Jet- oder Dispenstechnik erfolgt, wobei die Kupferpaste (i) 66 - 99 Gew.-% mindestens einer Art von jeweils einen Phosphoranteil von 0 bis ≤ 500 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 1 - 20 Gew.-% Vehikel enthält, wobei der mittlere Teilchendurchmesser der metallischen Partikel (i) und (ii) ≤ 15 µm beträgt, wobei die kupferreichen Kupfer/ Zink-Legierungen oder kupferreichen Kupfer/Zinn-Legierungen eine Zusammensetzung von 60 bis 99,5 Gew.-% Kupfer und 0,5 bis 40 Gew.-% Zink oder Zinn aufweisen, und wobei die zinnreichen Zinn/ Kupfer-, Zinn/Silber- oder Zinn/Kupfer/Silber-Legierungen eine Zusammensetzung von 95 - 99,5 Gew.- % Zinn und 0,5 - 5 Gew.-% Kupfer, Silber oder Kupfer plus Silber aufweisen.
   In einer zweiten Ausführungsform handelt es sich demnach um ein Verfahren zum stoffschlüssigen Verbinden eines elektronischen Bauteils mit einem Substrat, bei dem man
   a) ein elektronisches Bauteil mit einer ersten zu verbindenden Oberfläche und ein Substrat mit einer zweiten zu verbindenden Oberfläche bereitstellt,
   b) auf wenigstens eine der zu verbindenden Oberflächen eine Kupferpaste durch Siebdruckverfahren, Schablonendruckverfahren, Jet- oder Dispenstechnik appliziert und die die Schicht aus Kupferpaste trocknet,
   c) das elektronische Bauteil und das Substrat so anordnet, dass die erste zu verbindende Oberfläche des elektronischen Bauteils mit der zweiten zu verbindenden Oberfläche des Substrats über die getrocknete Kupferpaste in Kontakt steht und ein Lotmittel neben die Schicht aus getrockneter Kupferpaste appliziert und,
   d) die in Schritt c) geschaffene Anordnung bei einer im Bereich von 240 - 260 °C liegenden Löttemperatur verlötet, um eine stoffschlüssige Verbindung zwischen dem elektronischen Bauteil und dem Substrat zu erzeugen, wobei es sich bei dem in Verfahrensschritt c) verwendeten Lotmittel um eine Lotpaste oder um ein oder mehrere Lotformteile aus Lotmetall handelt, wobei die Applikation der Lotpaste durch Siebdruckverfahren, Schablonendruckverfahren, Jet- oder Dispenstechnik erfolgt, wobei die Kupferpaste (i) 66 - 99 Gew.-% mindestens einer Art von jeweils einen Phosphoranteil von 0 bis ≤ 500 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 1 - 20 Gew.-% Vehikel enthält, wobei der mittlere Teilchendurchmesser der metallischen Partikel (i) und (ii) ≤ 15 µm beträgt, wobei die kupferreichen Kupfer/ Zink-Legierungen oder kupferreichen Kupfer/Zinn-Legierungen eine Zusammensetzung von 60 bis 99,5 Gew.-% Kupfer und 0,5 bis 40 Gew.-% Zink oder Zinn aufweisen, und wobei die zinnreichen Zinn/ Kupfer-, Zinn/Silber- oder Zinn/Kupfer/Silber-Legierungen eine Zusammensetzung von 95 - 99,5 Gew.- % Zinn und 0,5 - 5 Gew.-% Kupfer, Silber oder Kupfer plus Silber aufweisen. Erfindungsgemäß wird unter elektronischem Bauteil ein Bestandteil einer elektrischen bzw. elektronischen Schaltung verstanden. Bei dem elektronischen Bauteil kann es sich beispielsweise um einen Chip, vorzugsweise einen Nacktchip (ungehauster Halbleiterchip), um eine Halbleiterdiode, um einen Transistor, um einen Widerstand oder um einen Kondensator handeln.

Im Rahmen der Erfindung wird unter Substrat ein Körper verstanden, mit dem das elektronische Bauteil verbunden ist. Beispielsweise kann es sich bei dem Substrat um eine Leiterplatte, um Direct-Bonded-Copper (DBC bzw. DCB) oder um einen Leadframe handeln.

Der Begriff Leiterplatte wird hierin synonym für Leiterkarte, Platine oder gedruckte Schaltung verwendet und beschreibt einen Träger für elektronische Bauteile. Leiterplatten bestehen aus elektrisch isolierendem Material mit daran haftenden, leitenden Verbindungen (Leiterbahnen). Als elektrisch isolierendes Material kann beispielsweise faserverstärkter Kunststoff verwendet werden.

Direct-Bonded-Copper bezeichnet eine keramische Platte (beispielsweise aus Aluminiumoxid, Aluminiumnitrid oder Berylliumoxid), wobei eine Oberfläche oder die beiden flächenmäßig größten, zueinander parallelen Oberflächen mit Kupfer über einen Oxidationsprozess bei hohen Temperaturen gebondet sind. Unter den gewählten Bedingungen bildet sich dabei ein Eutektikum aus Kupfer und Sauerstoff, das sich sowohl mit dem Kupfer als auch dem Oxid des Substrats verbindet.

Unter Leadframe wird ein IC (integrated circuit, Mikrochip)-Gehäuse verstanden, das im Wesentlichen nur aus einem Chipträger und Anschlussleitungen besteht. Der Begriff Leadframe wird hierin synonym mit den Begriffen Anschlussrahmen oder Chipträger verwendet. Der Chipträger weist ein Substrat auf, das dessen Grundgerüst bildet und aus Metall, beispielsweise Kupfer, Kupferlegierungen, einer Kombination von Kupfer mit einem Finisher (z.B. Nickel, Silber oder Gold), Eisen-Nickel-Legierungen oder anderen Invar-Legierungen gefertigt ist.

Das elektronische Bauteil weist wenigstens eine erste Oberfläche auf, die für die Verbindung des elektronischen Bauteils mit einer Oberfläche des Substrats über die in Schritt c1) durch die Zweischichtenkombination aus getrockneter Kupferpaste und Lotmittel oder die in Schritt c2) durch die getrocknete Kupferpaste geschaffene Kontaktschicht vorgesehen ist. Diese Oberfläche kann auch Teil einer größeren Oberfläche sein.

Das Substrat weist wenigstens eine zweite Oberfläche auf, die für die Verbindung des elektronischen Bauteils mit einer Oberfläche des Substrats über die in Schritt c1) durch die Zweischichtenkombination aus getrockneter Kupferpaste und Lotmittel oder die in Schritt c2) durch die getrocknete Kupferpaste geschaffene Kontaktschicht vorgesehen ist. Diese Oberfläche kann ebenfalls auch Teil einer größeren Oberfläche sein.

Die über die in Schritt c1) durch die Zweischichtenkombination aus getrockneter Kupferpaste und Lotmittel oder die in Schritt c2) durch die getrocknete Kupferpaste geschaffene Kontaktschicht mit dem Substrat in Verbindung stehende Oberfläche des elektronischen Bauteils wird erfindungsgemäß als "erste zu verbindende Oberfläche" bezeichnet, während die über die betreffende Kontaktschicht mit dem elektronischen Bauteil in Verbindung stehende Oberfläche des Substrats als "zweite zu verbindende Oberfläche" bezeichnet wird.

Üblicherweise ist auf wenigstens der ersten zu verbindenden Oberfläche des elektronischen Bauteils eine Metallisierungsschicht aufgebracht. Ebenfalls üblich ist es, dass auf wenigstens der zweiten zu verbindenden Oberfläche des Substrats eine Metallisierungsschicht aufgebracht ist. Üblicherweise besitzen sowohl elektronisches Bauteil als auch Substrat auf wenigstens den zu verbindenden Oberflächen eine Metallisierungsschicht. Es ist somit üblich, dass das elektronische Bauteil auf einer Oberfläche eine Metallisierungsschicht aufweist, die einer Metallisierungsschicht auf der Oberfläche des Substrats gegenüberliegt, und dass diese Metallisierungsschichten durch die Kontaktschicht miteinander in Verbindung stehen. Im Rahmen der Erfindung sind die üblicherweise vorhandenen Metallisierungsschichten des elektronischen Bauteils Teil des elektronischen Bauteils und die üblicherweise vorhandenen Metallisierungsschichten des Substrats Teil des Substrats.

Falls vorhanden, nimmt die Metallisierungsschicht vorzugsweise einen Flächenanteil von wenigstens 50%, mehr bevorzugt wenigstens 70%, noch mehr bevorzugt wenigstens 90% und ganz bevorzugt wenigstens 95%, wie zum Beispiel 100% von wenigstens einer der Oberflächen des elektronischen Bauteils ein. Auf dem Substrat nimmt die Metallisierungsschicht vorzugsweise einen Flächenanteil von wenigstens 50%, mehr bevorzugt wenigstens 70%, noch mehr bevorzugt wenigstens 90% und ganz bevorzugt wenigstens 95%, wie zum Beispiel 100%, der über die Kontaktschicht mit dem elektronischen Bauteil in Verbindung stehenden Oberfläche ein.

Bei der Metallisierungsschicht handelt es sich vorzugsweise um eine lötbare Schicht. Vorzugsweise enthält die Metallisierungsschicht mindestens ein Element, das aus der Gruppe ausgewählt ist, die aus Kupfer, Silber, Gold, Zinn und Palladium besteht. Die Metallisierungsschicht kann vollständig aus diesen Elementen, lötbaren Verbindungen dieser Elemente oder Mischungen oder Legierungen dieser Elemente bestehen.

In Schritt b) wird die Kupferpaste auf wenigstens eine der zu verbindenden Oberflächen von elektronischem Bauteil oder Substrat appliziert und getrocknet.

Bezogen auf ihr Gewicht enthält die Kupferpaste (i) 66 - 99 Gew.-%, vorzugsweise 68 - 95 Gew.-% und mehr bevorzugt 70 - 92 Gew.-% mindestens einer Art von jeweils einen Phosphoranteil von 0 bis ≤ 500 Gewichts-ppm, beispielsweise > 0 bis ≤ 500 Gewichts-ppm, bevorzugt ≥ 0 bis ≤ 100 Gewichts-ppm, mehr bevorzugt ≥ 0 bis ≤ 50 Gewichts-ppm und insbesondere ≥ 0 bis ≤ 10 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-%, bevorzugt 5 -15 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 1 - 20 Gew.-%, vorzugsweise 5 -15 Gew.-% Vehikel, wobei der mittlere Teilchendurchmesser der metallischen Partikel (i) und (ii) ≤ 15 µm beträgt.

Bevorzugt besteht die Kupferpaste, bezogen auf ihr Gewicht, aus (i) 66 - 99 Gew.-%, vorzugsweise 68 - 95 Gew.-% und mehr bevorzugt 70 - 92 Gew.-% mindestens einer Art von jeweils einen Phosphoranteil von 0 bis ≤ 500 Gewichts-ppm, beispielsweise > 0 bis ≤ 500 Gewichts-ppm, bevorzugt ≥ 0 bis ≤ 100 Gewichts-ppm, mehr bevorzugt ≥ 0 bis ≤ 50 Gewichts-ppm und insbesondere ≥ 0 bis ≤ 10 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-%, bevorzugt 5 -15 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 1 - 20 Gew.-%, vorzugsweise 5 -15 Gew.-% Vehikel, wobei der mittlere Teilchendurchmesser der metallischen Partikel (i) und (ii) ≤ 15 µm beträgt.

Die Reinheit des Kupfers der in der Kupferpaste enthaltenen Kupferpartikel beträgt vorzugsweise wenigstens 99,9 Gew.-% (3 N) und mehr bevorzugt wenigstens 99,99 Gew.-% (4 N). Im Falle der Partikel aus kupferreichen Kupfer/Zink-Legierungen bzw. kupferreichen Kupfer/ZinnLegierungen beträgt die Zusammensetzung 60 bis 99,5 Gew.-% Kupfer und entsprechend 0,5 bis 40 Gew.-% Zink bzw. Zinn. In jedem Falle liegt der Phosphoranteil bei allen Partikeln bei 0 bis ≤ 500 Gewichts-ppm, beispielsweise > 0 bis ≤ 500 Gewichts-ppm, bevorzugt ≥ 0 bis ≤ 100 Gewichts-ppm, mehr bevorzugt ≥ 0 bis ≤ 50 Gewichts-ppm und insbesondere ≥ 0 bis ≤ 10 Gewichts-ppm. Bevorzugt handelt es sich bei den Partikeln um durch Verdüsung unter Inertgasatmosphäre hergestellte Partikel oder, mit anderen Worten, um durch Verdüsung von flüssigem (geschmolzenem) Kupfer bzw. einer Schmelze einer der besagten Kupferlegierungen in eine Inertgasatmosphäre hinein hergestellte Partikel.

Wie schon gesagt, in einer Ausführungsform kann die Kupferpaste mindestens eine Art von Lotmetallpartikeln (ii) ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe enthalten.

Sind in der Kupferpaste Lotmetallpartikel aus zinnreichen Zinn/Kupfer-, Zinn/Silber- bzw. Zinn/Kupfer/Silber-Legierungen enthalten, so liegt deren Zinnanteil im Bereich von 95 - 99,5 Gew.-%, während der Anteil von Kupfer und/oder Silber dementsprechend im Bereich von 0,5 - 5 Gew.-% liegt.

Die mittleren Teilchendurchmesser der metallischen Partikel (i) und (ii) betragen ≤ 15 µm, vorzugsweise ≤ 13 µm, mehr bevorzugt ≤ 11 µm und noch mehr bevorzugt ≤ 8 µm. Vorzugsweise liegt der mittlere Teilchendurchmesser im Bereich von 2 - 15 µm, mehr bevorzugt im Bereich von 2 - 13 µm, noch mehr bevorzugt im Bereich von 2 - 11 µm und ganz besonders bevorzugt im Bereich von 2 - 8 µm.

Der hierin verwendete Begriff "mittlerer Teilchendurchmesser" bedeutet die mit einem optischen Mikroskop bestimmbare mittlere Teilchengröße (d50). Derartige Messungen können mit einem optischen Mikroskop beispielsweise bei einer 200-fachen Vergrößerung in Kombination mit einem üblichen digitalen Bildverarbeitungssystem (CCD-Digitalkamera und Auswertesoftware), beispielsweise einem Mess-System von Microvision Instruments, durchgeführt werden. Beispielsweise kann ein mittlerer Teilchendurchmesser von ≤ 15 µm bedeuten, dass wenigstens 90 Prozent der Partikel einen Teilchendurchmesser von ≤ 15 µm und weniger als 10 Prozent der Partikel einen Teilchendurchmesser von mehr als 15 µm aufweisen. Ein mittlerer Teilchendurchmesser im Bereich von 2 - 15 µm bedeutet dann dementsprechend, dass wenigstens 90 Prozent der Partikel einen Teilchendurchmesser im Bereich von 2 - 15 µm und weniger als 10 Prozent der Partikel einen Teilchendurchmesser von weniger als 2 µm oder mehr als 15 µm aufweisen.

Erfindungsgemäß kann es bevorzugt sein, dass weniger als 1 Prozent der Partikel (i) und (ii) einen bestimmten Teilchendurchmesser überschreiten. Dieser Teilchendurchmesser, der von weniger als 1 Prozent der Partikel (i) und (ii) überschritten werden darf, beträgt vorzugsweise 15 µm, mehr bevorzugt 11 µm und noch mehr bevorzugt 8 µm.

Die Partikel (i) und (ii) können unterschiedliche Geometrien aufweisen. Die Partikel (i) und (ii) weisen jedoch vorzugsweise eine sphärische Form auf. Dem Fachmann ist jedoch klar, dass von den eingesetzten Partikeln (i) und (ii) herstellungsbedingt auch ein untergeordneter Anteil eine nichtsphärische Form aufweisen kann. Es ist jedoch bevorzugt, dass wenigstens 90 Gew.- %, mehr bevorzugt wenigstens 95 Gew.-%, noch mehr bevorzugt wenigstens 99 Gew.-% oder 100 Gew.-% der Partikel (i) und (ii) in sphärischer Form vorliegen. Es ist auch bevorzugt, dass in der Kupferpaste weniger als 5 Gew.-%, mehr bevorzugt weniger als 1 Gew.-%, noch mehr bevorzugt weniger als 0,1 Gew.-%, so zum Beispiel 0 Gew.-% der Partikel (i) und (ii) in der Form von Flakes vorliegen.

Neben den Metallpartikeln vom Typ (i) und gegebenenfalls (ii) umfasst die Kupferpaste ein sogenanntes Vehikel (iii), welches einen oder mehrere gegebenenfalls modifizierte natürliche Verdicker (beispielsweise Gelatine, Stärke, Pektin, Celluloseether, Ester natürlicher organischer Öle) und organische Lösemittel (beispielsweise Glykol, Glycerin, Terpineol, aliphatische Kohlenwasserstoffe) umfasst oder daraus besteht. Der Verdickeranteil des Vehikels liegt beispielsweise bei 0,5 - 15 Gew.-%, vorzugsweise bei 2 - 10 Gew.-% und mehr bevorzugt bei 4 - 7 Gew.-%, während der Lösemittelanteil bei 85 - 99,5 Gew.-%, vorzugsweise bei 90 - 98 Gew.-% und mehr bevorzugt bei 93 - 96 Gew.-% liegt.

Die Applikation der Kupferpaste in Verfahrensschritt b) erfolgt durch eines der aus dem Stand der Technik bekannten Verfahren, beispielsweise Siebdruckverfahren, Schablonendruckverfahren, Jet- oder Dispenstechnik. Es ist nicht erforderlich, dass die Kupferpaste die gesamte Oberfläche des elektronischen Bauteils oder des Substrats bedeckt. Vielmehr kann die Kupferpaste auch nur auf Teile der Oberfläche des elektronischen Bauteils oder Substrats, beispielsweise auf ausgewählte Lötflächen, appliziert werden. Die Kupferpaste wird beispielsweise in einer Schichtdicke von 20 - 200 µm appliziert und dann getrocknet, beispielweise für 10 - 60 Minuten bei einer Objekttemperatur von 50 - 160° C. Danach schließt sich Verfahrensschritt c1) oder c2) an.

Bei dem in Verfahrensschritt c1) oder c2) verwendeten Lotmittel handelt es sich um eine Lotpaste oder um ein oder mehrere Lotformteile aus Lotmetall. Beim Lotmittel in Form einer Lotpaste kann letztere, bezogen auf ihr Gewicht, (a) 80 - 99 Gew.- %, vorzugsweise 85 - 95 Gew.-% und mehr bevorzugt 87 - 92 Gew.-% mindestens einer Art von Lotmetallpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe, und (b) 1 - 20 Gew.-%, vorzugsweise 5 -15 Gew.-% und mehr bevorzugt 8 - 13 Gew.-% Flussmittel oder Vehikel enthalten. Bevorzugt besteht die Lotpaste, bezogen auf ihr Gewicht, aus (a) 80 - 99 Gew.-%, vorzugsweise 85 - 95 Gew.-% und mehr bevorzugt 87 - 92 Gew.-% mindestens einer Art von Lotmetallpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe, und (b) 1 - 20 Gew.-%, vorzugsweise 5 -15 Gew.-% und mehr bevorzugt 8 - 13 Gew.-% Flussmittel oder Vehikel.

Sind in der Lotpaste Lotmetallpartikel aus zinnreichen Zinn/Kupfer-, Zinn/Silber- bzw. Zinn/Kupfer/Silber-Legierungen enthalten, so liegt deren Zinnanteil beispielsweise im Bereich von 95 - 99,5 Gew.-%, während der Anteil von Kupfer und/oder Silber dementsprechend im Bereich von 0,5 - 5 Gew.-% liegt.

Hinsichtlich der mittleren Teilchendurchmesser der Zinn- oder zinnreichen Partikel gilt das Gleiche wie vorstehend zu den mittleren Teilchendurchmessern der Metallpartikel (i) und (ii) gesagt.

Falls die Lotpaste Flussmittel enthält, so ist es dessen Aufgabe, die Oberfläche des Substrats und/oder des elektronischen Bauteils beim Löten zu reduzieren (d.h. zu entoxidieren), die erneute Oxidbildung vor und während des Lötvorgangs zu verhindern und Einschlüsse von Fremdstoffen zu verringern. Ferner soll durch den Zusatz des Flussmittels die Oberflächenspannung des flüssigen Lotes verringert werden. Als Flussmittel können beispielsweise Kolophonium, auf Kolophonium basierende Harzsysteme, auf Wasser basierende Harzsysteme oder Systeme auf der Basis von Carbonsäuren (z.B. Carbonsäuren wie Zitronensäure, Adipinsäure, Zimtsäure und Benzylsäure), Aminen (z.B. tertiäre Amine) und Lösemitteln (z.B. polare Lösemittel, enthaltend Wasser und ein Polyol, wie Glykol oder Glycerin) verwendet werden.

Daneben können in der Lotpaste weitere Bestandteile, wie zum Beispiel Alkohole, Fettsäuren (z.B. gesättigte Fettsäuren, wie Ölsäure, Myristinsäure, Palmitinsäure, Margarinsäure, Stearinsäure oder Arachinsäure), Polysiloxan-Verbindungen oder Phosphid-Verbindungen, enthalten sein.

Wie schon gesagt, kann die Lotpaste anstelle von Flussmittel sogenanntes Vehikel enthalten. Um unnötige Wiederholungen zu vermeiden, wird auf die vorstehend im Zusammenhang mit der Beschreibung der Kupferpaste zum Vehikel gemachten Ausführungen verwiesen.

Die Applikation der Lotpaste in Verfahrensschritt c1) oder c2) erfolgt durch eines der aus dem Stand der Technik bekannten Verfahren, beispielsweise Siebdruckverfahren, Schablonendruckverfahren oder Jet- oder Dispenstechnik. In der Verfahrensschritt c1) umfassenden Ausführungsform des erfindungsgemäßen Verfahrens wird die Lotpaste auf die getrocknete Kupferpaste appliziert, in der Verfahrensschritt c2) umfassenden Ausführungsform neben die getrocknete Kupferpaste. Im letzteren Fall kann so gearbeitet werden, dass die Lotpaste die getrocknete Kupferpaste von der Seite her berührt oder einen geringen Abstand von beispielsweise bis zu 2 mm zu der getrockneten Kupferpaste hat; beim späteren Löten in Verfahrensschritt d) verfließt die Lotpaste schließlich und infiltriert unterstützt durch den Kapillareffekt die getrocknete Kupferpastenmatrix. Die Lotpaste wird beispielsweise in einer Nassschichtdicke von 20 - 200 µm appliziert und gegebenenfalls getrocknet, beispielweise für 10 - 60 Minuten bei einer Objekttemperatur von 50 - 160 °C.

Beim Lotmittel in Form von mindestens einem Formteil aus Lotmetall handelt es sich beispielsweise um Kügelchen, Folie, Draht oder Zylinder. Die Formteile werden ausgewählt aus der aus Zinn-Formteilen, zinnreichen Zinn/Kupfer-Legierungsformteilen, zinnreichen Zinn/Silber-Legierungsformteilen und zinnreichen Zinn/Kupfer/Silber-Legierungsformteilen bestehenden Gruppe. Im Falle der zinnreichen Zinn/Kupfer-, Zinn/Silber- bzw. Zinn/Kupfer/SilberLegierungen liegt deren Zinnanteil beispielsweise im Bereich von 95 - 99,5 Gew.-%, während der Anteil von Kupfer und/oder Silber dementsprechend im Bereich von 0,5 - 5 Gew.-% liegt.

Die Applikation des mindestens einen Lotmetallformteils besteht üblicherweise in einem simplen Platzieren. In der Verfahrensschritt c1) umfassenden Ausführungsform des erfindungsgemäßen Verfahrens wird mindestens ein Lotmetallformteil auf die getrocknete Kupferpaste platziert, in der Verfahrensschritt c2) umfassenden Ausführungsform neben die getrocknete Kupferpaste. Im letzteren Fall kann so gearbeitet werden, dass das mindestens eine Lotmetallformteil die getrocknete Kupferpaste von der Seite her berührt oder einen geringen Abstand von beispielsweise bis zu 2 mm zu der getrockneten Kupferpaste hat; beim späteren Löten in Verfahrensschritt d) schmilzt und verfließt das mindestens eine Lotmetallformteil schließlich und infiltriert unterstützt durch den Kapillareffekt die getrocknete Kupferpastenmatrix.

Weder die Kupferpaste noch das Lotmittel enthalten Blei und sind damit bleifrei. Erfindungsgemäß ist unter bleifrei zu verstehen, dass Kupferpaste und Lotmittel abgesehen von gegebenenfalls vorhandenen, technisch bedingten Blei-Verunreinigungen kein Blei enthalten. Unter bleifrei wird demnach ein Bleigehalt von unter 1, vorzugsweise unter 0,5, mehr bevorzugt unter 0,1, noch mehr bevorzugt unter 0,01 Gew.-% und insbesondere 0 Gew.-% auf Basis des Gewichts der Kupferpaste bzw. des Lotmittels verstanden.

Elektronisches Bauteil und Substrat werden erfindungsgemäß durch Löten stoffschlüssig miteinander verbunden. Stoffschlüssige Verbindungen sind demnach Verbindungen, bei denen die Verbindungspartner durch atomare oder molekulare Kräfte zusammengehalten werden. Sie stellen vorzugsweise nicht lösbare Verbindungen dar, die sich nur durch Zerstörung der Verbindungsmittel trennen lassen. Zunächst wird eine Anordnung gebildet, die aus dem Substrat, dem elektronischen Bauteil und einer zwischen Substrat und elektronischem Bauteil befindlichen Zweischichtenkombination aus getrockneter Kupferpaste und Lotmittel oder aus dem Substrat, dem elektronischen Bauteil und einer zwischen Substrat und elektronischem Bauteil befindlichen Schicht aus getrockneter Kupferpaste mit daneben appliziertem Lotmittel besteht. Dementsprechend sind Substrat und elektronisches Bauteil so angeordnet, dass die erste zu verbindende Oberfläche des Substrats und die zweite zu verbindende Oberfläche des elektronischen Bauteils miteinander über die Zweischichtenkombination aus getrockneter Kupferpaste und Lotmittel oder über die getrocknete Kupferpaste mit daneben appliziertem Lotmittel in Kontakt stehen.

Üblicherweise steht die besagte Zweischichtenkombination oder die getrocknete Kupferpaste dabei vorzugsweise mit der üblicherweise vorhandenen Metallisierungsschicht des Substrats und der üblicherweise vorhandenen Metallisierungsschicht des elektronischen Bauteils in Kontakt.

Vorzugsweise wird in der den Verfahrensschritt c1) aufweisenden Ausführungsform des erfindungsgemäßen Verfahrens dazu zunächst wie vorstehend beschrieben eine Zweischichtenkombination aus der getrockneten Kupferpaste und dem Lotmittel auf die zu verbindende Oberfläche des Substrats, vorzugsweise auf die eine Metallisierungsschicht aufweisende Oberfläche des Substrats, appliziert. Anschließend wird das elektronische Bauteil mit einer Oberfläche, vorzugsweise mit der die Metallisierungsschicht aufweisenden Oberfläche, auf die Zweischichtenkombination aus der getrockneten Kupferpaste und dem Lotmittel gesetzt.

Vorzugsweise wird in der Verfahrensschritt c2) umfassenden Ausführungsform des erfindungsgemäßen Verfahrens dazu zunächst wie vorstehend beschrieben eine Schicht aus der getrockneten Kupferpaste auf die zu verbindende Oberfläche des Substrats, vorzugsweise auf die eine Metallisierungsschicht aufweisende Oberfläche des Substrats, appliziert. Dann wird das Lotmittel wie vorstehend beschrieben neben die Schicht aus der getrockneten Kupferpaste appliziert. Anschließend wird das elektronische Bauteil mit einer Oberfläche, vorzugsweise mit der die Metallisierungsschicht aufweisenden Oberfläche, auf die getrocknete Kupferpaste gesetzt.

Bei beiden Alternativen des erfindungsgemäßen Verfahrens, d.h. sowohl bei der Verfahrensschritt c1) als auch bei der Verfahrensschritt c2) aufweisenden Ausführungsform des erfindungsgemäßen Verfahrens, wird in Verfahrensschritt d) die Anordnung aus elektronischem Bauteil, Substrat und dazwischen befindlicher Zweischichtenkombination aus getrockneter Kupferpaste und Lotmittel bzw. Schicht aus getrockneter Kupferpaste mit daneben appliziertem Lotmittel (d.h. mit die getrocknete Kupferpaste von der Seite her berührendem oder einen geringen Abstand von beispielsweise bis zu 2 mm zu der getrockneten Kupferpaste aufweisendem Lotmittel) schließlich unter Bildung einer Anordnung aus elektronischem Bauteil, Substrat und dazwischenliegender Kontaktschicht gelötet. Unter Löten wird dabei gemäß der allgemeinen Definition ein thermisches Verfahren zum stoffschlüssigen Fügen von Werkstoffen verstanden, wobei die Solidustemperatur der Werkstoffe nicht erreicht wird.

Zum Löten wird die vorstehend beschriebene Anordnung vorzugsweise gleichmäßig bis zum Erreichen der eigentlichen Löttemperatur erhitzt. Gemäß einer bevorzugten Ausführungsform erfolgt das Erhitzen mit einer Geschwindigkeit von ≤ 3 °C pro Sekunde.

Die Löttemperatur liegt vorzugsweise etwa 10- 50 °C, mehr bevorzugt etwa 15 - 45 °C und noch mehr bevorzugt etwa 25 - 35 °C, zum Beispiel etwa 30 °C über der Schmelztemperatur des im Lotmittel enthaltenen Lotmetalls. Gemäß der erfindungsgemäßen Ausführungsform liegt die Löttemperatur im Bereich von 240 - 260 °C.

Zum Löten wird die Temperatur für eine Zeit von wenigstens 15 Sekunden, vorzugsweise von wenigstens 20 Sekunden und noch mehr bevorzugt von wenigstens 30 Sekunden über der Liquidustemperatur des im Lotmittel enthaltenen Lotmetalls aufrechterhalten.

Es wird angenommen, dass es während des Abkühlens der gelöteten Anordnung unter die Liquidustemperatur des Lotmetalls aus dem Lotmittel zu einer Diffusion des von den Partikeln (i) der Kupferpaste stammenden Kupfers in eine beim Lötvorgang entstandene eutektische Zinn-Kupfer-Phase kommt.

Es kann vorteilhaft sein, die beim Lötvorgang erhaltene Anordnung aus elektronischem Bauteil, Substrat und dazwischenliegender Kontaktschicht nach dem Lötvorgang zu tempern. Unter Tempern wird eine Wärmebehandlung der Anordnung unterhalb der Liquidustemperatur des Lots verstanden.

Die Wärmebehandlung erfolgt vorzugsweise bei einer Temperatur von über 40 °C, beispielsweise im Bereich von 40 - 217 °C, mehr bevorzugt im Bereich von 100 - 210 °C und noch mehr bevorzugt im Bereich von 150 - 205 °C. Das Tempern erfolgt vorzugsweise für eine Dauer von 1 Minute bis zu 24 Stunden, mehr bevorzugt für 10 Minuten bis zu 10 Stunden und noch mehr bevorzugt für 20 Minuten bis zu 1 Stunde. Die Temperdauer korreliert üblicherweise mit der Temperatur und ist umso länger, je niedriger die Temperatur zum Tempern ist.

Das erfindungsgemäße Verfahren erfordert keine kostspieligen Abänderungen der üblichen Verfahren zur Herstellung von Anordnungen aus elektronischem Bauteil, Substrat und dazwischenliegender Kontaktschicht. Insbesondere stellt das erfindungsgemäße Verfahren auch keine besonderen Anforderungen an die für herkömmliche Lötprozesse verwendeten Maschinen.

So kann das erfindungsgemäße Verfahren beispielsweise unter herkömmlichen Bedingungen und unter Einsatz der gegebenenfalls bereits vorhandenen Maschinen durchgeführt werden.

Gemäß einer bevorzugten Ausführungsform ist die erfindungsgemäße Anordnung durch das vorstehend beschriebene Verfahren herstellbar oder wird mit diesem Verfahren hergestellt.

In der erfindungsgemäßen Anordnung beträgt der Abstand zwischen elektronischem Bauteil und Substrat beispielsweise 20 bis 200 µm. Dieser Abstand versteht sich als Abstand zwischen den zu verbindenden Oberflächen von elektronischem Bauteil und Substrat, wobei die üblicherweise vorhandenen Metallisierungsschichten dem elektronischen Bauteil bzw. dem Substrat zuzuordnen sind. Der genannte Abstand entspricht somit der Dicke der Kontaktschicht zwischen elektronischem Bauteil und Substrat, d.h. nach dem Löten.

Erfindungsgemäß können beim vorstehend beschriebenen Lötvorgang die Lötbedingungen, Auftragsdicke der Kupferpaste, Menge bzw. Auftragsdicke des Lotmittels, Temperatur und Zeit, sowie ggf. die Temperbedingungen, insbesondere Temperatur und Zeit, so eingestellt werden, dass die vorstehend beschriebene Kontaktschicht erhalten wird. Die Erzeugung der Kontaktschicht mit den gewünschten Eigenschaften kann auf einfache Weise durch Auswertung entsprechender Schliffbilder nachvollzogen werden.

### Beispiele:

### Erfindungsgemäßes Beispiel 1:

Es wurde eine Kupferpaste hergestellt, die 91 Gewichtsprozent Kupferpartikel mit einem mittleren Teilchendurchmesser von 8 µm und einem Phosphoranteil von 5 Gewichts-ppm aufwiesen, und 9 Gewichtsprozent eines Vehikels (Ethylcellulose in organischer Lösung) enthielt.

Die Kupferpaste wurde durch eine Metallschablone auf ein Kupferblech aufgetragen. Die Auftragsdicke der Kupferpaste betrug 80 µm. Anschließend wurde die mit der Kupferpaste versehene Oberfläche des Kupferblechs maschinell mit einem 3 mm x 3 mm großen Nacktchip bestückt, der eine Metallisierungsschicht aus Nickel/Silber aufwies. Hierzu wurde der Nacktchip so auf die Kupferpaste gesetzt, dass die Metallisierungsschicht des Nacktchips mit dem Kupfefrblech über die Kupferpaste in Kontakt stand. Unmittelbar neben dieser Anordnung wurde ein Lotformteil (Lotdraht aus SnAg3,OCu0,5-Legierung mit 0,5 mm Durchmesser und 3 mm Länge) auf das Kupferblech appliziert.

Nunmehr wurde diese Anordnung aus Kupferblech, Nacktchip, dazwischen angeordneter Kupferpaste und appliziertem Lotformteil in einen Kammer-Lötofen eingebracht, mit einer Rate von 0,5 Kelvin pro Sekunde auf eine Temperatur von 60 °C erhitzt und bei dieser Temperatur für 1 h unter Inertgasatmosphäre getrocknet. Unmittelbar danach erfolgte eine Erhöhung der Temperatur auf 200 °C, eine Aktivierung/Reduktion der Reaktionsoberflächen, d.h. des Lotformteils, der Kupferpartikel in der getrockneten Kupferpasten-Zwischenschicht und der Kupferblech-Oberfläche mittels Ameisensäure-gesättigter Stickstoffatmosphäre. Danach erfolgte im gleichen Lötofen eine Erhöhung der Temperatur auf 260 °C und die Lötung dieser Anordnung unter Vakuum (1 mbar) in einer Lötzeit von 10 min.

### Erfindungsgemäßes Beispiel 2:

Es wurde wie in Beispiel 1 gearbeitet mit dem einzigen Unterschied, dass der Phosphoranteil der Kupferpartikel 500 Gewichts-ppm betrug.

### Vergleichsbeispiel 3:

Es wurde wie in Beispiel 1 gearbeitet mit dem einzigen Unterschied, dass der Phosphoranteil der Kupferpartikel 1100 Gewichts-ppm betrug.

### Referenzbeispiel 4:

In Anlehnung an Beispiel 1 wurde eine vergleichbare Anordnung erstellt; allerdings erfolgte dies ohne Verwendung einer Kupferpaste.

Der Nacktchipgröße von 3 mm x 3 mm entsprechend wurde ein Lotformteil in Form einer 0,1 mm dicken Folie aus der SnAg3,OCu0,5-Legierung gefertigt, auf das Kupferblech appliziert und darauf wiederum der Nacktchip gesetzt. Die Lötung dieser Anordnung erfolgte wie in Beispiel 1, allerdings ohne den dort beschriebenen Trocknungschritt, bei gleichen Aktivierungsparametern und reduzierter Löttemperatur von 240 °C.

In verschiedenen Versuchen zur Festigkeit der gemäß den Beispielen 1 bis 4 hergestellten Lötverbindungen bzw. verlöteten Anordnungen wurde festgestellt, dass die Lötverbindungen der gemäß erfindungsgemäßen Beispielen 1 und 2 hergestellten Anordnungen eine wesentlich höhere Scherfestigkeit bei 200 °C aufwiesen als die der gemäß Vergleichsbeispiel 3 oder gemäß Referenzbeispiel 4 hergestellten Anordnungen.

## Patentansprüche

1. Verfahren zum stoffschlüssigen Verbinden eines elektronischen Bauteils mit einem Substrat, bei dem man
a) ein elektronisches Bauteil mit einer ersten zu verbindenden Oberfläche und ein Substrat mit einer zweiten zu verbindenden Oberfläche bereitstellt,
b) auf wenigstens eine der zu verbindenden Oberflächen eine Kupferpaste durch Siebdruckverfahren, Schablonendruckverfahren, Jet- oder Dispenstechnik appliziert und die Schicht aus Kupferpaste trocknet,
c1) ein Lotmittel auf die getrocknete Schicht aus Kupferpaste appliziert und das elektronische Bauteil und das Substrat so anordnet, dass die erste zu verbindende Oberfläche des elektronischen Bauteils mit der zweiten zu verbindenden Oberfläche des Substrats über die Zweischichtenkombination aus getrockneter Kupferpaste und Lotmittel in Kontakt steht,
oder
c2) das elektronische Bauteil und das Substrat so anordnet, dass die erste zu verbindende Oberfläche des elektronischen Bauteils mit der zweiten zu verbindenden Oberfläche des Substrats über die getrocknete Kupferpaste in Kontakt steht und ein Lotmittel neben die Schicht aus getrockneter Kupferpaste appliziert, und
d) die in Schritt c1) oder c2) geschaffene Anordnung bei einer im Bereich von 240 - 260 °C liegenden Löttemperatur verlötet, um eine stoffschlüssige Verbindung zwischen dem elektronischen Bauteil und dem Substrat zu erzeugen,
wobei es sich bei dem in Verfahrensschritt c1) oder c2) verwendeten Lotmittel um eine Lotpaste oder um ein oder mehrere Lotformteile aus Lotmetall handelt,
wobei die Applikation der Lotpaste durch Siebdruckverfahren, Schablonendruckverfahren, Jet- oder Dispenstechnik erfolgt,
wobei die Kupferpaste (i) 66 - 99 Gew.-% mindestens einer Art von jeweils einen Phosphoranteil von 0 bis ≤ 500 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 1 - 20 Gew.-% Vehikel enthält, wobei der mittlere Teilchendurchmesser der metallischen Partikel (i) und (ii) ≤ 15 µm beträgt,
wobei die kupferreichen Kupfer/Zink-Legierungen oder kupferreichen Kupfer/ZinnLegierungen eine Zusammensetzung von 60 bis 99,5 Gew.-% Kupfer und 0,5 bis 40 Gew.-% Zink oder Zinn aufweisen, und
wobei die zinnreichen Zinn/Kupfer-, Zinn/Silber- oder Zinn/Kupfer/Silber-Legierungen eine Zusammensetzung von 95 - 99,5 Gew.-% Zinn und 0,5 - 5 Gew.-% Kupfer, Silber oder Kupfer plus Silber aufweisen,

2. Verfahren nach Anspruch 1,
wobei der Phosphoranteil ≥ 0 bis ≤ 100 Gewichts-ppm beträgt.

3. Verfahren nach einem der vorhergehenden Ansprüche,
wobei es sich bei den Partikeln vom Typ (i) um durch Verdüsung unter Inertgasatmosphäre hergestellte Partikel handelt.

4. Verfahren nach einem der vorhergehenden Ansprüche,
wobei das Vehikel 0,5 - 15 Gew.% eines oder mehrerer gegebenenfalls modifizierter natürlicher Verdicker und 85 - 99,5 Gew.-% organisches Lösemittel umfasst oder aus 0,5 - 15 Gew.% eines oder mehrerer gegebenenfalls modifizierter natürlicher Verdicker und 85 - 99,5 Gew.-% organischen Lösemittels besteht.

5. Verfahren nach einem der vorhergehenden Ansprüche,
wobei das Lotmittel in Verfahrensschritt c2) so neben die getrocknete Kupferpaste appliziert wird, dass es die getrocknete Kupferpaste von der Seite her berührt oder einen geringen Abstand von bis zu 2 mm zu der getrockneten Kupferpaste hat.

6. Verfahren nach einem der vorhergehenden Ansprüche,
wobei das elektronische Bauteil ein Chip, eine Halbleiterdiode, ein Transistor, ein Widerstand oder ein Kondensator ist.

7. Verfahren nach einem der vorhergehenden Ansprüche,
wobei das Substrat eine Leiterplatte, ein Direct-Bonded-Copper oder ein Leadframe ist.

8. Verfahren nach einem der vorhergehenden Ansprüche,
wobei die nach Abschluss von Schritt d) erhaltene Anordnung bei einer Temperatur im Bereich von 40-217 °C für eine Dauer von 1 Minute bis zu 24 Stunden getempert wird.

## Claims

1. Method for material-bonded connection of an electronic component to a substrate, comprising
a) providing an electronic component having a first surface that is to be connected and a substrate having a second surface that is to be connected;
b) applying a copper paste onto at least one of the surfaces that are to be connected by means of screen printing processes, stencil printing processes, jet or dispensing technique, and drying the layer of copper paste;
c) applying a soldering agent onto the dried layer of copper paste and arranging the electronic component and the substrate appropriately such that the first surface to be connected of the electronic component contacts the second surface to be connected of the substrate via the two-layer combination of dried copper paste and soldering agent;
or
c2) arranging the electronic component and the substrate appropriately such that the first surface to be connected of the electronic component contacts the second surface to be connected of the substrate via the dried copper paste, and applying a soldering agent adjacent to the layer of dried copper paste; and
d) soldering the arrangement produced in step c1) or c2) at a soldering temperature in the range of 240 - 260°C in order to produce a material-bonded connection between the electronic component and the substrate; whereby the soldering agent used in process step c1) or c2) is a soldering paste or one or more solder form parts made of soldering metal; whereby the application of the soldering paste takes place by means of screen printing processes, stencil printing processes, jet or dispensing technique; whereby the copper paste contains (i) 66 - 99% by weight of at least one type of particles, which each comprise a phosphorus fraction ranging from 0 to ≤ 500 wt-ppm selected from the group consisting of copper particles, copper-rich copper/zinc alloy particles, and copper-rich copper/tin alloy particles, (ii) 0 - 20% by weight of at least one type of soldering particles selected from the group consisting of tin particles, tin-rich tin/copper alloy particles, tin-rich tin/silver alloy particles, and tin-rich tin/copper/silver alloy particles, and (iii) 1 - 20%by weight of vehicle, whereby the mean particle diameter of the metallic particles (i) and (ii) is ≤ 15 µm;
whereby the copper-rich copper/zinc alloys or copper-rich copper/tin alloys comprise a composition ranging from 60 - 99.5% by weight copper and 0.5 - 40% by weight zinc or tin, and
whereby the tin-rich tin/copper alloys, tin/silver alloys or tin/copper/silver alloys comprise a composition ranging from 95 - 99.5% by weight tin and 0.5 - 5% by weight copper, silver or copper plus silver.

2. Method according to claim 1,
whereby the phosphorus fraction is ≥ 0 to ≤ 100 wt-ppm.

3. Method according to any one of the preceding claims,
whereby the particles of type (i) are particles produced by atomisation in an inert gas atmosphere.

4. Method according to any one of the preceding claims,
whereby the vehicle comprises 0.5 - 15% by weight of one or more possibly modified natural thickening agent(s) and 85 - 95.5% by weight organic solvent or consists of 0.5 - 15% by weight of one or more possibly modified natural thickening agent(s) and 85 - 95.5% by weight organic solvent.

5. Method according to any one of the preceding claims,
whereby the soldering agent in process step c2) is applied appropriately adjacent to the dried copper paste such it touches the dried copper paste from the side or resides at a low distance of up to 2 mm from the dried copper paste.

6. Method according to any one of the preceding claims,
whereby the electronic component is a chip, a semiconductor diode, a transistor, a resistor or a capacitor.

7. Method according to any one of the preceding claims,
whereby the substrate is a printed circuit board, a direct-bonded-copper or a lead frame.

8. Method according to any one of the preceding claims,
whereby the arrangement obtained after completion of step d) is tempered at a temperature in the range of 40 - 217°C for a period of time ranging from 1 minute to up to 24 hours.

## Revendications

1. Procédé de liaison par complémentarité de matières d'un composant électronique avec un substrat, dans lequel on
a) prépare un composant électronique avec une première surface à relier et un substrat avec une seconde surface à relier,
b) applique sur au moins une des surfaces à relier une pâte de cuivre par impression par sérigraphie, impression par pochoir, technique de jet ou dispersion et sèche la couche de pâte de cuivre,
c1) applique un plomb à braser sur la couche de pâte de cuivre sèche et agence le composant électronique et le substrat de telle façon que la première surface à relier du composant électronique soit en contact avec la seconde surface du substrat à relier par la combinaison bi-couches de pâte de cuivre séchée et de plomb à braser,
ou
c2) agence le composant électronique et le substrat de telle façon que la première surface à relier du composant électronique soit en contact avec la seconde surface du substrat à relier par la pâte de cuivre séchée et on applique un plomb à braser près de la couche de pâte de cuivre séchée, et
d) brase l'agencement créé à l'étape c1) ou c2) à une température de brasage située dans la plage de 240 - 260°C, pour produire une liaison par complémentarité de matières entre le composant électronique et le substrat,
dans lequel le plomb à braser employé à l'étape c1) ou c2) du procédé est une pâte à braser ou une ou plusieurs pièce(s) à braser en métal à braser,
dans lequel l'application de la pâte à braser est effectuée par impression par sérigraphie, impression par pochoir, technique de jet ou dispersion,
dans lequel la pâte de cuivre est constituée de (i) 66 - 99 % en poids d'au moins un type de respectivement une teneur en phosphore de particules présentant 0 à ≤ 500 poids-ppm sélectionnées parmi le groupe constitué de particules de cuivre, de particules d'alliage cuivre/zinc riches en cuivre et de particules d'alliage cuivre/étain riches en cuivre, (ii) 0 - 20 % en poids d'au moins un type de particules de brasage sélectionnées parmi le groupe constitué de particules d'étain, de particules d'alliage étain/cuivre riches en étain, de particules d'alliage étain/argent riches en étain et de particules d'alliage cuivre/étain/argent riches en étain et (iii) contient 1 - 20 % en poids de véhicule, dans lequel le diamètre de particule moyen des particules métalliques (i) et (ii) est ≤ 15 µm,
dans lequel les alliages cuivre/zinc riches en cuivre ou les alliages cuivre/étain riches en cuivre présentent une composition de 60 à 99,5 % en poids de cuivre et 0,5 à 40 % en poids de zinc ou d'étain, et
dans lequel les alliages étain/cuivre, étain/argent ou étain/cuivre/argent riches en étain présentent une composition de 95 - 99,5 % en poids d'étain et de 0,5 - 5 % en poids de cuivre, d'argent ou de cuivre plus argent.

2. Procédé selon la revendication 1, dans lequel la teneur en phosphore est ≥ 0 à ≤ 100 poids-ppm.

3. Procédé selon l'une des revendications précédentes, dans lequel les particules du type (i) sont des particules fabriquées par aération par pulvérisation ou sous atmosphère de gaz inertes.

4. Procédé selon l'une des revendications précédentes, dans lequel le véhicule comprend 0,5 - 15 % en poids d'un, ou le cas échéant plusieurs, épaississant naturel modifié et 85 - 99,5 % en poids de solvant organique ou est composé de 0,5 - 15 % en poids d'un, ou le cas échéant plusieurs, épaississant naturel modifié et de 85 - 99,5 % en poids de solvant organique.

5. Procédé selon l'une des revendications précédentes, dans lequel le plomb à braser à l'étape c2) du procédé est appliqué si près de la pâte de cuivre séchée qu'il touche la pâte de cuivre séchée par le côté ou a une distance allant jusqu'à 2 mm de la pâte de cuivre séchée.

6. Procédé selon l'une des revendications précédentes, dans lequel le composant électronique est une puce, une diode à semi-conducteur, un transistor, une résistance ou un condensateur.

7. Procédé selon l'une des revendications précédentes, dans lequel le substrat est un circuit comprimé, un direct-bonded-copper ou un leadframe.

8. Procédé selon l'une des revendications précédentes, dans lequel l'agencement obtenu à la fin de l'étape d) est étuvé à une température située dans la plage de 40 - 217°C pendant une durée de 1 minute à 24 heures.
